# FASCICULE DE BREVET EUROPEEN

(11) **EP 0 555 124 B1**
(45) Date de publication et mention de la délivrance du brevet: **13.05.1998**
(21) Numéro de dépôt: 93400191.8
(22) Date de dépôt: 26.01.1993
(51) Int. Cl.: C30B 11/00

(54) **Superalliage monocristallin à base de nickel à tenue à l'oxydation améliorée et procédé de préparation**
Einkristalline Superlegierung auf Nickelbasis mit verbesserte Oxydationsbeständigkeit und Verfahren zu seiner Herstellung
Nickel base single crystal superalloy with improved oxydation resistance and process for producing it

(30) Priorité: 05.02.1992 FR 9201302
(43) Date de publication de la demande: 11.08.1993
(73) Titulaire: OFFICE NATIONAL D'ETUDES ET DE RECHERCHES AEROSPATIALES, 92322 Chatillon sous Bagneux (FR)
(72) Inventeur: Khan, Tasadduq, F-78350 Jouy en Josas (FR); Caron, Pierre, F-91940 Les Ulis (FR)
(74) Mandataire: Plaçais, Jean-Yves

(56) Documents cités:
- EP-A- 0 240 451
- EP-A- 0 246 082
- EP-A- 0 395 812
- EP-A- 0 413 439
- GB-A- 2 194 960
- US-A- 4 162 918
- US-A- 4 240 828

## Description

L'invention concerne les superalliages à base de nickel adaptés à la solidification monocristalline, appelés ci-après superalliages monocristallins, notamment pour l'élaboration d'aubes de turbomachines.

En pratique, les aubes de turbines en superalliages sont presque toujours revêtues d'une couche protectrice contre les effets néfastes de la corrosion et de l'oxydation. Cependant, il est important que la résistance à l'environnement du matériau nu soit bonne, afin d'éviter une dégradation accélérée de l'alliage lorsque le revêtement est endommagé en cours de service.

L'accroissement des performances des turbines à gaz va de pair avec les augmentations de température et de durée de fonctionnement. Cette évolution nécessite, en particulier, l'amélioration de la tenue à l'oxydation à haute température des alliages existants.

EP-A-0 395 812 et US-A-4 162 918 décrivent des superalliages à base de nickel contenant des petites quantités d'erbium.

L'invention vise à améliorer la tenue à l'oxydation à haute température de différents superalliages monocristallins à base de nickel par des modifications mineures de composition chimique, tout en maintenant un même niveau de résistance en fluage.

Ce résultat est obtenu selon l'invention, de façon surprenante, en incorporant au superalliage au moins un élément choisi parmi l'erbium et le silicium, à une concentration pondérale de 50 à 500 ppm pour Er et de 500 à 1000 ppm pour Si, et optionnellement de l'hafnium à une concentration pondérale de 500 à 1000 ppm, à un superalliage monocristallin à base de nickel où les concentrations pondérales des éléments autres que Ni, Er, Si et Hf sont comprises dans les domaines suivants :

| | |
|---|---|
| Cr | 6 à 10 % |
| Co | 4 à 8 % |
| W | 4,8 à 9 % |
| Mo | 0 à 2,5 % |
| Al | 4,5 à 6,2 % |
| Ti | 0 à 2,2 % |
| Ta | 3,3 à 9 % |
| B | ≤ 100 ppm |
| C | ≤ 100 ppm |
| Zr | ≤ 100 ppm. |

L'invention vise également un procédé de préparation d'un superalliage tel que défini ci-dessus, dans lequel les éléments Er et/ou Si et le cas échéant Hf sont introduits au cours de l'élaboration de la coulée mère de l'alliage, ou au cours de la refusion précédant la solidification monocristalline.

Des caractéristiques optionnelles avantageuses du procédé selon l'invention sont énoncées ci-après :
- La solidification monocristalline est suivie des étapes successives de traitement thermique ci-après :
   a) mise en solution de la phase γ' par chauffage à une température comprise entre 1250 et 1350°C, à l'intérieur de la fenêtre de traitement thermique de l'alliage, pendant 30 minutes à 4 heures, puis refroidissement à l'air;
   b) précipitation de la phase γ' par chauffage à une température supérieure à 1000°C; et
   c) augmentation de la fraction volumique de la phase γ' par chauffage à une température comprise entre 800 et 900°C, pendant une durée suffisante pour obtenir une taille de précipités γ' de l'ordre de 0,5 micromètre.
- L'étape a) comporte un palier à environ 1300°C pendant 3 heures environ, l'étape b) un palier à 1050°C environ pendant 16 heures environ et l'étape c) un palier à 850°C environ pendant 24 heures environ, ces deux derniers paliers étant suivis chacun d'un refroidissement à l'air.
- L'étape a) comporte un palier à 1300 °C environ pendant 3 heures environ, l'étape b) un palier à 1100°C environ pendant 4 heures environ et l'étape c) un palier à 850°C environ pendant 24 heures environ, ces deux derniers paliers étant suivis chacun d'un refroidissement à l'air.
- L'étape a) comporte un palier à 1285°C environ pendant 2 heures suivi d'une montée à 1295°C environ en 1 heure environ et d'un palier à cette dernière température pendant 2 heures environ, l'étape b) comporte un palier à 1100°C environ pendant 5 heures environ et l'étape c) comporte un palier à 850°C environ pendant 24 heures environ, ces deux dernières étapes comportant chacune un refroidissement à l'air.

L'invention vise enfin une aube de turbomachine réalisée en un superalliage, et/ou obtenue par le procédé, tels que définis plus haut.

D'autres caractéristiques et avantages de l'invention apparaîtront à l'examen de la description détaillée ci-après, et des dessins annexés, sur lesquels :

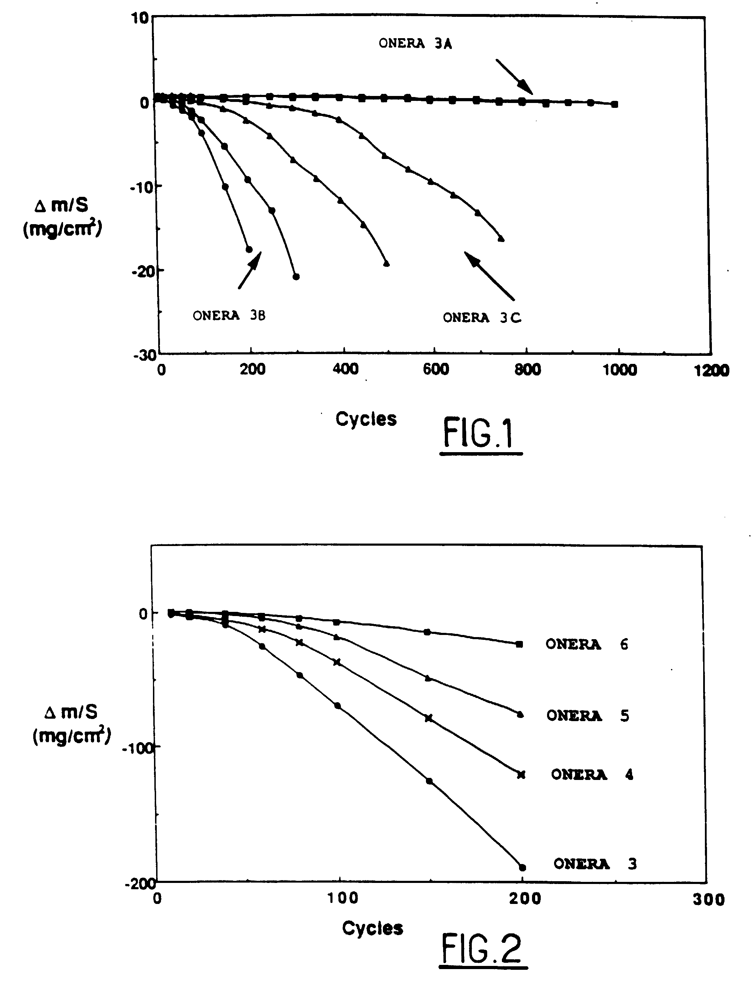

- les figures 1 à 4 sont des graphiques qui rendent compte de la résistance à l'oxydation à chaud de différents alliages.

### EXEMPLE I

Cet exemple est relatif à l'amélioration de l'alliage appelé ONERA 3, décrit dans FR-A-2 599 757.

La résistance au fluage à haute température de cet alliage ONERA 3 se compare favorablement à celles des meilleurs superalliages connus antérieurement, avec une masse volumique significativement inférieure, sensiblement égale à 8,25 g.cm⁻³.

Sa composition pondérale est sensiblement la suivante :

| | |
|---|---|
| Cr | 8,1 % |
| Co | 5,5 % |
| W | 5,0 % |
| Mo | 2,2 % |
| Al | 6,1 % |
| Ti | 2,0 % |
| Ta | 3,4 % |
| B | ≤ 10 ppm |
| Zr | ≤ 50 ppm |
| Ni | complément à 100 %. |

On a élaboré par refusions successives suivies de solidification dirigée des monocristaux d'alliages appelés ONERA 3A, ONERA 3B et ONERA 3C, dérivés de l'alliage ONERA 3 par l'adjonction respectivement de 200 à 250 ppm en poids de Er, de 60 à 120 ppm en poids de Er et de 30 à 90 ppm en poids de Er. Des observations micrographiques effectuées sur des monocristaux non traités thermiquement montrent la présence de phases riches en erbium dans les espaces interdendritiques des alliages ONERA 3A et ONERA 3B.

Après application d'un traitement de mise en solution de la phase γ' à 1300°C, l'observation de la microstructure de ces alliages révèle la présence de brûlures dues à la fusion des phases riches en erbium. Les alliages subissent ensuite un premier revenu à 1050°C pendant 16 heures puis un second revenu à 850°C pendant 24 heures.

Des échantillons des alliages ONERA 3A et 3C ont été testés en oxydation cyclique à 1100°C sous air en même temps que des échantillons de l'alliage ONERA 3 de référence.

Le cycle thermique d'oxydation consiste en une montée en température en 10 minutes, suivie d'un maintien à 1100°C pendant 60 minutes, puis d'un refroidissement sous air forcé pendant 3 minutes.

La cinétique d'oxydation est suivie par pesée des échantillons, tous les 20 cycles jusqu'à 100 cycles, puis tous les 50 cycles jusqu'à 1000 cycles.

Les résultats de ces tests d'oxydation sont illustrés par les courbes de la figure 1.

L'alliage ONERA 3A montre une tenue en oxydation très fortement améliorée par rapport à celle de l'alliage ONERA 3. L'alliage ONERA 3C montre une tenue à l'oxydation intermédiaire entre celle de l'alliage le plus chargé en erbium et celle de l'alliage de référence.

Cette étude a permis de définir une teneur optimale en erbium dans l'alliage ONERA 3 permettant d'améliorer de manière significative la tenue en oxydation cyclique à 1100°C de cet alliage, tout en permettant une remise en solution totale de la phase γ' sans provoquer l'apparition de brûlures dues à la présence de phases riches en erbium et caractérisées par un bas point de fusion.

L'invention vise ainsi des alliages dont la composition pondérale est définie par les fourchettes suivantes :

| | |
|---|---|
| Cr | 7,8 à 8,3 % |
| Co | 5,0 à 6,0 % |
| W | 4,8 à 5,2 % |
| Mo | 2,1 à 2,4 % |
| Al | 5,8 à 6,1 % |
| Ti | 1,8 à 2,2 % |
| Ta | 3,3 à 3,7 % |
| Er | 50 à 100 ppm |
| B | ≤ 10 ppm |
| Zr | ≤ 50 ppm |
| Ni | complément à 100 %. |

On a élaboré, par fusion suivie de solidification monocristalline trois alliages appelés respectivement ONERA 4, ONERA 5 et ONERA 6, dont les compositions pondérales sont indiquées dans le tableau 1. L'alliage ONERA 4 est caractérisé par une teneur de 100 ppm en Er et correspond aux spécifications détaillées ci-dessus. L'alliage ONERA 5 est caractérisé par une addition volontaire de 500 ppm de silicium. L'alliage ONERA 6 contient 500 ppm de silicium et 1000 ppm de hafnium.

**Tableau 1**

| Elément | Concentration pondérale en % | | |
|---|---|---|---|
| | ONERA 4 | ONERA 5 | ONERA 6 |
| Cr | 8 | 8 | 8 |
| Co | 5,5 | 5,5 | 5,5 |
| W | 5 | 5 | 5 |
| Mo | 2,25 | 2,25 | 2,25 |
| Al | 6 | 6 | 6 |
| Ti | 2 | 2 | 2 |
| Ta | 3,5 | 3,5 | 3,5 |
| B | - | - | - |
| C | - | - | - |
| Zr | - | - | - |
| Er | 0,01 | - | - |
| Si | - | 0,05 | 0,05 |
| Hf | - | - | 0,1 |
| Ni | Complément à 100 | | |

Dans le tableau 1, le signe "-" signifie l'absence d'addition volontaire de l'élément considéré.

Les masses volumiques des alliages ONERA 4, ONERA 5 et ONERA 6 sont sensiblement égales à 8,25 g.cm⁻³.

Dans l'alliage ONERA 4 contenant 100 ppm en poids de Er, la structure brute de solidification monocristalline est exempte de phases interdendritiques riches en erbium. L'application d'un traitement thermique à haute température, tel que défini auparavant, permet donc de remettre totalement en solution les particules de phase γ' sans provoquer l'apparition de brûlures.

Les additions de Hf et de Si dans l'alliage ONERA 3 entraînent une réduction de la fenêtre de traitement thermique. Des concentrations trop élevées en Si et Hf peuvent ainsi conduire à une disparition totale de la fenêtre de traitement thermique ne permettant alors plus de remettre en solution les particules de phase γ', ce qui serait préjudiciable à la tenue en fluage de l'alliage.

Le choix judicieux des concentrations en éléments Si et Hf dans les alliages ONERA 5 et ONERA 6 permet de conserver des fenêtres de traitement thermique telles que l'on peut remettre totalement, ou en très grande partie, en solution la phase γ' sans risque de brûlures.

Des essais comparatifs d'oxydation cyclique à 1100°C ont été effectués sur les alliages ONERA 3, 4, 5 et 6 après qu'ils aient subi les traitements thermiques définis plus haut.

Les essais d'oxydation cyclique ont été effectués dans les conditions suivantes : maintien pendant une heure à l'air à 1100°C dans un four, puis maintien hors du four pendant 15 minutes. Les échantillons sont pesés tous les dix cycles afin de déterminer les variations de masse par unité de surface.

Les résultats de ces essais sont illustrés par les courbes de la figure 2.

Par rapport à l'alliage ONERA 3, ces courbes font apparaître une amélioration sensible de la tenue à l'oxydation pour l'alliage ONERA 4, une amélioration plus importante pour l'alliage ONERA 5 et une amélioration très importante pour l'alliage ONERA 6.

Les caractéristiques de fluage des alliages ONERA 4, ONERA 5 et ONERA 6 ont été déterminées sur des monocristaux orientés selon <001> ayant subi les traitements thermiques décrits auparavant, et comparées à celles de l'alliage ONERA 3 ayant subi les mêmes traitements.

Le tableau 2 donne, pour chaque alliage, et pour différentes conditions de température et de contraintes, le temps nécessaire pour atteindre une déformation de 1%, et au-dessous de celui-ci le temps nécessaire pour la rupture.

**Tableau 2**

| Conditions d'essai | | Temps de fluage (h) | | | |
|---|---|---|---|---|---|
| Température (°C) | Contrainte (MPa) | ONERA 3 | ONERA 4 | ONERA 5 | ONERA 6 |
| 760 | 750 | 132 | 193 | 107 | 111 |
| | | 782 | 1212 | 767 | 645 |
| 850 | 500 | 72 | 77 | 103 | 67 |
| | | 248 | 237 | 277 | 254 |
| 1050 | 140 | 206 | 148 | 138 | 256 |
| | | 282 | 278 | 200 | 356 |

Ces résultats montrent que la résistance optimale à l'oxydation à 1100°C de l'alliage ONERA 3 est obtenue par des additions conjointes de Hf et de Si, dans des proportions telles que la microstructure et la résistance au fluage de l'alliage ne sont pas modifiées.

L'invention vise des alliages dont la composition pondérale est définie par les fourchettes suivantes :

| | |
|---|---|
| Cr | 7,8 à 8,3 % |
| Co | 5,0 à 6,0 % |
| W | 4,8 à 5,2 % |
| Mo | 2,1 à 2,4 % |
| Al | 5,8 à 6,1 % |
| Ti | 1,8 à 2,2 % |
| Ta | 3,3 à 3,7 % |
| Si | 500 à 700 ppm |
| Hf | 800 à 1500 ppm |
| B | ≤ 10 ppm |
| Zr | ≤ 50 ppm |
| Ni | complément à 100 %. |

### EXEMPLE II

On part cette fois d'un alliage de base appelé MC2, dont la composition pondérale, comprise dans le domaine divulgué par FR-A-2 557 598, est la suivante :

| | |
|---|---|
| Cr | 8 % |
| Co | 5 % |
| W | 8 % |
| Mo | 2 % |
| Al | 5 % |
| Ti | 1,5 % |
| Ta | 6 % |
| Ni | complément à 100 %. |

Deux alliages modifiés par des additions d'erbium et de silicium ont été élaborés par fusion puis solidification dirigée sous forme de barreaux monocristallins d'orientation <001>.

L'alliage X contient 800 ppm en poids d'erbium et 1300 ppm en poids de silicium. L'alliage Y contient 400 ppm en poids d'erbium et 550 ppm en poids de silicium.

L'analyse de la microstructure des alliages modifiés dans l'état monocristallin non traité révèle la présence de phases riches en erbium dans les espaces interdendritiques.

Les traitements thermiques suivants ont été appliqués aux alliages X et Y : maintien à 1300°C pendant 3 heures, suivi d'un refroidissement à l'air afin de remettre en solution les précipités de phase γ'; traitement de précipitation à 1100°C pendant 4 heures suivi d'un refroidissement à l'air afin d'obtenir une répartition homogène de précipités cubiques de phase γ' ayant une taille moyenne de 400 nm; traitement de revenu à 850°C pendant 24 heures suivi d'un refroidissement à l'air afin d'augmenter la fraction volumique de phase γ'.

Après le traitement de mise en solution à 1300°C, des brûlures sont observées dans les régions interdendritiques de l'alliage X, mais non dans celles de l'alliage Y.

Des échantillons des alliages MC2, X et Y ont été testés en oxydation cyclique à 1100°C dans les mêmes conditions que celles décrites précédemment.

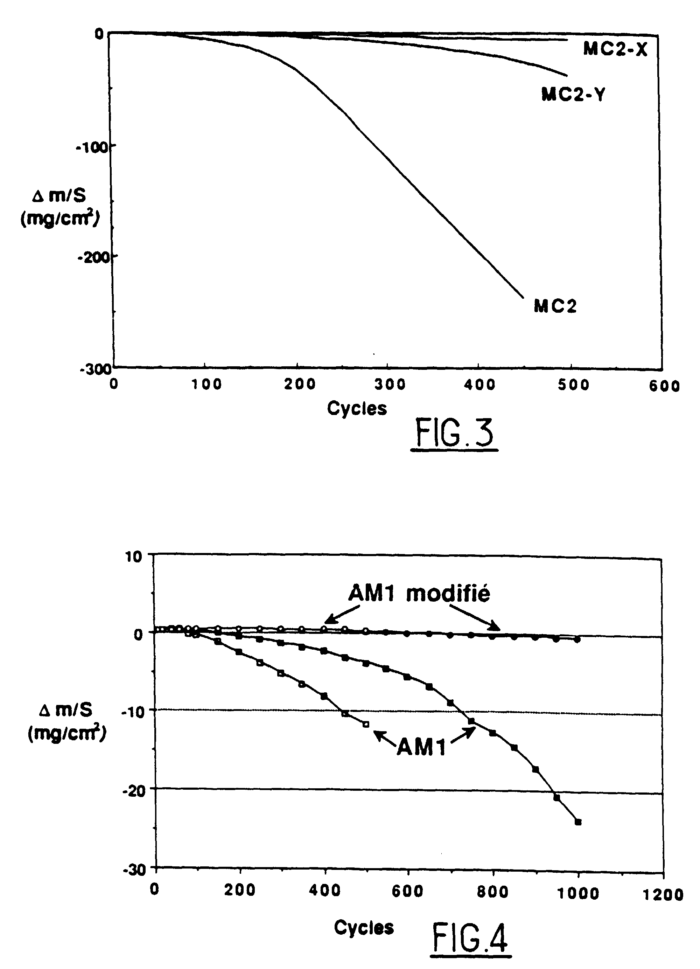

Les résultats de ces essais sont illustrés par les courbes de la figure 3.

Les alliages X et Y montrent une tenue à l'oxydation très nettement améliorée par rapport à celle de l'alliage de référence.

Des essais de fluage ont été effectués sur des éprouvettes usinées dans des barreaux monocristallins <001> en alliage Y et traitées selon le cycle décrit ci-dessus. Dans le tableau 3, les caractéristiques de fluage à différentes températures sont comparées à celles obtenues sur des monocristaux <001> en alliage MC2 traités dans les mêmes conditions. Les temps de fluage ont la même signification que dans le tableau 2.

Compte tenu des dispersions typiquement observées pour ce type d'alliage, les caractéristiques de fluage sont comparables pour les deux alliages considérés.

L'invention vise des alliages dont la composition pondérale est définie par les fourchettes suivantes :

| | |
|---|---|
| Cr | 7,7 à 8,2 % |
| Co | 4,8 à 5,4 % |
| W | 7,7 à 8,2 % |
| Mo | 1,8 à 2,2 % |
| Al | 4,85 à 5,1 % |
| Ti | 1,3 à 1,6 % |
| Ta | 6 % |
| C | < 0,01 % |
| Si | 500 à 700 ppm |
| Er | 50 à 400 ppm |
| Ni | complément à 100 %. |

**Tableau 3**

| Conditions d'essai | | Temps de fluage (h) | |
|---|---|---|---|
| Température (°C) | Contrainte (MPa) | MC2 | Y |
| 850 | 500 | 161 | 155 |
| | | 594 | 566 |
| 950 | 240 | 266 | 229 |
| | | 728 | 620 |
| 1050 | 145 | 400 | 398 |
| | | 441 | 472 |

### EXEMPLE III

Cet exemple est relatif à un alliage appelé AM1, couvert également par FR-A-2 557 598, et dont la composition pondérale est la suivante :

| | |
|---|---|
| Cr | 7,5 % |
| Co | 6,5 % |
| W | 5,5 % |
| Mo | 2 % |
| Al | 5,2 % |
| Ti | 1,2 % |
| Ta | 8 % |
| Ni | complément à 100 %. |

Un alliage modifié contenant 980 ppm de silicium et 1000 ppm de hafnium a été élaboré par fusion puis solidification dirigée sous forme de barreaux monocristallins d'orientation <001>.

Dans l'alliage de référence, un traitement thermique de 3 heures à 1300°C est communément utilisé afin de remettre en solution la quasi-totalité de la phase γ'. Dans l'alliage modifié, l'addition de hafnium et de silicium entraîne une augmentation de la fraction volumique de phase γ' eutectique interdendritique et une diminution de la température de solidus de l'alliage. En conséquence, l'application d'un traitement thermique à 1300°C entraîne l'apparition de brûlures dans les régions interdendritiques, résultant du début de fusion de la phase γ' eutectique.

Dans le cas de cet alliage modifié, nos avons donc utilisé un traitement étagé de mise en solution de la phase γ', consistant en un premier traitement thermique de 2 heures à 1285°C, suivi d'une montée en température en une heure jusqu'à 1295°C, puis d'un palier de 2 heures à 1295°C suivi d'un refroidissement à l'air. Ce traitement conduit à une remise en solution de la phase γ' comparable à celle obtenue dans l'alliage de référence après un traitement de 3 heures à 1300°C.

A la suite des traitements de mise en solution de la phase γ', les monocristaux de l'alliage de référence et de l'alliage modifié ont été soumis à un premier revenu à 1100°C pendant 5 heures, puis à un second revenu à 870°C pendant 16 heures, tous deux suivis d'un refroidissement à l'air.

Des échantillons des deux alliages ont été testés en oxydation cyclique à 1100°C. Les résultats de ces essais sont illustrés par les courbes de la figure 4, deux de ces essais ayant été volontairement interrompus après 500 cycles environ, pour examen des échantillons.

L'alliage modifié montre une résistance à l'oxydation très nettement améliorée par rapport à celle de l'alliage de référence.

Des essais de fluage à différentes températures ont été effectués sur des éprouvettes usinées dans des barreaux monocristallins <001> de l'alliage de référence et de l'alliage modifié, traités selon la procédure décrite auparavant. Les caractéristiques de fluage de ces deux alliages sont rassemblées dans le tableau 4.

**Tableau 4**

| Conditions d'essai | | Temps de rupture en fluage (h) | |
|---|---|---|---|
| Température (°C) | Contrainte (MPa) | Alliage de référence | Alliage modifié |
| 760 | 750 | 582 | 937 |
| 850 | 500 | 326 | 361 |
| 950 | 240 | 450 | 402 |

Compte tenu des dispersions typiquement observées pour ce type d'alliage, les temps de rupture en fluage sont comparables pour les deux alliages considérés.

Ces résultats montrent que les traitements thermiques décrits en dernier lieu conviennent à des alliages selon l'invention comportant sensiblement la composition pondérale suivante :

| | |
|---|---|
| Cr | 7,5 % |
| Co | 6,5 % |
| W | 5,5 % |
| Mo | 2 % |
| Al | 5,2 % |
| Ti | 1,2 % |
| Ta | 8 % |
| Si | 1000 ppm |
| Hf | 1000 ppm |
| Ni | complément à 100 %. |

Les exemples ci-dessus n'ont aucun caractère limitatif. Une amélioration sensible de la résistance à l'oxydation ayant été constatée pour des alliages de base de trois compositions très différentes à l'intérieur du domaine spécifié, il n'y a aucune raison de penser qu'il n'en est pas de même dans tout ce domaine.

## Revendications

1. Superalliage monocristallin à base de nickel convenant à l'élaboration d'aubes de turbomachines, caractérisé en ce qu'il contient au moins un élément choisi parmi l'erbium et le silicium, à une concentration pondérale de 50 à 500 ppm pour Er et de 500 à 1000 ppm pour Si, et optionnellement en outre de l'hafnium à une concentration pondérale de 500 à 1500 ppm, les concentrations pondérales des éléments autres que Ni, Er, Si et Hf étant comprises dans les domaines suivants :
| | |
|---|---|
| Cr | 6 à 10 % |
| Co | 4 à 8 % |
| W | 4,8 à 9 % |
| Mo | 0 à 2,5 % |
| Al | 4,5 à 6,2 % |
| Ti | 0 à 2,2 % |
| Ta | 3,3 à 9 % |
| B | ≤ 100 ppm |
| C | ≤ 100 ppm |
| Zr | ≤ 100 ppm. |

2. Superalliage selon la revendication 1, caractérisé en ce que sa composition pondérale est comprise dans le domaine suivant :
| | |
|---|---|
| Cr | 7,8 à 8,3 % |
| Co | 5,0 à 6,0 % |
| W | 4,8 à 5,2 % |
| Mo | 2,1 à 2,4 % |
| Al | 5,8 à 6,1 % |
| Ti | 1,8 à 2,2 % |
| Ta | 3,3 à 3,7 % |
| Er | 50 à 100 ppm |
| B | ≤ 10 ppm |
| Zr | ≤ 50 ppm |
| Ni | complément à 100 %. |

3. Superalliage selon la revendication 1, caractérisé en ce que sa composition pondérale est comprise dans le domaine suivant :
| | |
|---|---|
| Cr | 7,8 à 8,3 % |
| Co | 5,0 à 6,0 % |
| W | 4,8 à 5,2 % |
| Mo | 2,1 à 2,4 % |
| Al | 5,8 à 6,1 % |
| Ti | 1,8 à 2,2 % |
| Ta | 3,3 à 3,7 % |
| Si | 500 à 700 ppm |
| Hf | 800 à 1500 ppm |
| B | ≤ 10 ppm |
| Zr | ≤ 50 ppm |
| Ni | complément à 100 %. |

4. Superalliage selon la revendication 1, caractérisé en ce que sa composition pondérale est comprise dans le domaine suivant :
| | |
|---|---|
| Cr | 7,7 à 8,2 % |
| Co | 4,8 à 5,4 % |
| W | 7,7 à 8,2 % |
| Mo | 1,8 à 2,2 % |
| Al | 4,85 à 5,1 % |
| Ti | 1,3 à 1,6 % |
| Ta | 6% |
| C | < 0,01 % |
| Si | 500 à 700 ppm |
| Er | 50 à 400 ppm |
| Ni | complément à 100 %. |

5. Superalliage selon la revendication 1, caractérisé en ce que sa composition pondérale est sensiblement la suivante :
| | |
|---|---|
| Cr | 7,5 % |
| Co | 6,5 % |
| W | 5,5 % |
| Mo | 2 % |
| Al | 5,2 % |
| Ti | 1,2 % |
| Ta | 8 % |
| Si | 1000 ppm |
| Hf | 1000 ppm |
| Ni | complément à 100 %. |

6. Procédé de préparation d'un superalliage selon l'une des revendications précédentes, dans lequel les éléments Er et/ou Si et le cas échéant Hf sont introduits au cours de l'élaboration de la coulée mère de l'alliage.

7. Procédé de préparation d'un superalliage selon l'une des revendications 1 à 5, dans lequel les éléments Er et/ou Si et le cas échéant Hf sont introduits au cours de la refusion précédant la solidification monocristalline.

8. Procédé selon l'une des revendications 6 et 7, caractérisé en ce que la solidification monocristalline est suivie des étapes successives de traitement thermique ci-après :
a) mise en solution de la phase γ' par chauffage à une température comprise entre 1250 et 1350°C, à l'intérieur de la fenêtre de traitement thermique de l'alliage, pendant 30 minutes à 4 heures, puis refroidissement à l'air;
b) précipitation de la phase γ' par chauffage à une température supérieure à 1000°C; et
c) augmentation de la fraction volumique de la phase γ' par chauffage à une température comprise entre 800 et 900°C, pendant une durée suffisante pour obtenir une taille de précipités γ' de l'ordre de 0,5 micromètre.

9. Procédé selon la revendication 8 pour l'obtention d'un alliage selon la revendication 2, caractérisé en ce que l'étape a) comporte un palier à environ 1300°C pendant 3 heures environ, l'étape b) un palier à 1050°C environ pendant 16 heures environ et l'étape c) un palier à 850°C environ pendant 24 heures environ, ces deux derniers paliers étant suivis chacun d'un refroidissement à l'air.

10. Procédé selon la revendication 8 pour l'obtention d'un alliage selon la revendication 4, caractérisé en ce que l'étape a) comporte un palier à 1300 °C environ pendant 3 heures environ, l'étape b) un palier à 1100°C environ pendant 4 heures environ et l'étape c) un palier à 850°C environ pendant 24 heures environ, ces deux derniers paliers étant suivis chacun d'un refroidissement à l'air.

11. Procédé selon la revendication 8 pour l'obtention d'un alliage selon la revendication 5, caractérisé en ce que l'étape a) comporte un palier à 1285°C environ pendant 2 heures suivi d'une montée à 1295°C environ en 1 heure environ et d'un palier à cette dernière température pendant 2 heures environ, que l'étape b) comporte un palier à 1100°C environ pendant 5 heures environ et que l'étape c) comporte un palier à 850°C environ pendant 24 heures environ, ces deux dernières étapes comportant chacune un refroidissement à l'air.

12. Aube de turbomachine réalisée en un superalliage selon l'une des revendications 1 à 5, et/ou obtenue par le procédé selon l'une des revendications 6 à 11.

## Patentansprüche

1. Einkristalline Superlegierung auf Nickelbasis, die für die Herstellung von Schaufeln für Turbomaschinen geeignet ist,
**dadurch gekennzeichnet,**
daß sie wenigstens ein Element, ausgewählt aus Erbium und Silizium, mit einem Gewichtsanteil von 50 bis 500 ppm für Er und von 500 bis 1000 ppm für Si enthält, und daß sie fakultativ außerdem Hafnium mit einem Gewichtsanteil von 500 bis 1500 ppm enthält, wobei die Gewichtsanteile von anderen Elementen als Ni, Er, Si und Hf in den folgenden Bereichen liegen:
| | |
|---|---|
| Cr | 6 bis 10 % |
| Co | 4 bis 8 % |
| W | 4,8 bis 9 % |
| Mo | 0 bis 2,5 % |
| Al | 4,5 bis 6,2 % |
| Ti | 0 bis 2,2 % |
| Ta | 3,3 bis 9 % |
| B | ≤ 100 ppm |
| C | ≤ 100 ppm |
| Zr | ≤ 100 ppm. |

2. Superlegierung nach Anspruch 1,
**dadurch gekennzeichnet,**
daß ihre Gewichtszusammensetzung in dem folgenden Bereich liegt:
| | |
|---|---|
| Cr | 7,8 bis 8,3 % |
| Co | 5,0 bis 6,0 % |
| W | 4,8 bis 5,2 % |
| Mo | 2,1 bis 2,4 % |
| Al | 5,8 bis 6,1 % |
| Ti | 1,8 bis 2,2 % |
| Ta | 3,3 bis 3,7 % |
| Er | 50 bis 100 ppm |
| B | ≤ 10 ppm |
| Zr | ≤ 50 ppm |
| Ni | Ergänzung auf 100 %. |

3. Superlegierung nach Anspruch 1,
**dadurch gekennzeichnet,**
daß ihre Gewichtszusammensetzung in dem folgenden Bereich liegt:
| | |
|---|---|
| Cr | 7,8 bis 8,3 % |
| Co | 5,0 bis 6,0 % |
| W | 4,8 bis 5,2 % |
| Mo | 2,1 bis 2,4 % |
| Al | 5,8 bis 6,1 % |
| Ti | 1,8 bis 2,2 % |
| Ta | 3,3 bis 3,7 % |
| Si | 500 bis 700 ppm |
| Hf | 800 bis 1500 ppm |
| B | ≤ 10 ppm |
| Zr | ≤ 50 ppm |
| Ni | Ergänzung auf 100 %. |

4. Superlegierung nach Anspruch 1,
**dadurch gekennzeichnet,**
daß ihre Gewichtszusammensetzung in dem folgenden Bereich liegt:
| | |
|---|---|
| Cr | 7,7 bis 8,2 % |
| Co | 4,8 bis 5,4 % |
| W | 7,7 bis 8,2 % |
| Mo | 1,8 bis 2,2 % |
| Al | 4,85 bis 5,1 % |
| Ti | 1,3 bis 1,6 % |
| Ta | 6,0 % |
| C | < 0,01 ppm |
| Si | 500 bis 700 ppm |
| Zr | 50 bis 400 ppm |
| Ni | Ergänzung auf 100 %. |

5. Superlegierung nach Anspruch 1,
**dadurch gekennzeichnet,**
daß ihre Gewichtszusammensetzung im wesentlichen die folgende ist:
| | |
|---|---|
| Cr | 7,5 % |
| Co | 6,5 % |
| W | 5,5 % |
| Mo | 2 % |
| Al | 5,2 % |
| Ti | 1,2 % |
| Ta | 8 % |
| Si | 1000 ppm |
| Hf | 1000 ppm |
| Ni | Ergänzung auf 100 %. |

6. Verfahren zum Herstellen einer Superlegierung nach einem der vorhergehenden Ansprüche, wobei die Elemente Er und/oder Si und gegebenenfalls Hf während der Herstellung der Mutterschmelze der Legierung eingebracht werden.

7. Verfahren zur Herstellung einer Superlegierung nach einem der Ansprüche 1 bis 5,
wobei die Elemente Er und/oder Si und gegebenenfalls Hf während des Umschmelzens eingebracht werden, das der einkristallinen Verfestigung vorausgeht.

8. Verfahren nach einem der Ansprüche 6 und 7,
**dadurch gekennzeichnet,**
daß auf die einkristalline Verfestigung aufeinanderfolgende thermische Behandlungsschritte folgen, die nachstehend angegeben sind:
a) In Lösung bringen der γ'-Phase durch Erwärmen auf eine Temperatur zwischen 1250°C und 1350°C im Inneren des thermischen Behandlungsfensters der Legierung mit einer Dauer von 30 Minuten bis 4 Stunden und anschließendes Abkühlen an der Luft;
b) Abscheidung der γ'-Phase durch Erwärmen auf eine Temperatur oberhalb von 1000°C; und
c) Erhöhung der Volumenfraktion der γ'-Phase durch Erwärmen auf eine Temperatur zwischen 800°C und 900°C während einer Zeitdauer, die ausreicht, um eine Größe der γ'-Abscheidungen im Bereich von 0,5 µm zu erhalten.

9. Verfahren nach Anspruch 8 für die Darstellung einer Legierung nach Anspruch 2,
**dadurch gekennzeichnet,**
daß der Schritt a) eine Stufe mit etwa 1300°C mit einer Dauer von etwa 3 Stunden aufweist,
daß der Schritt b) eine Stufe mit etwa 1050°C mit einer Dauer von etwa 16 Stunden aufweist,
und daß der Schritt c) eine Stufe mit etwa 850°C mit einer Dauer von etwa 24 Stunden aufweist, wobei diese zwei letzten Stufen jeweils von einem Abkühlen an Luft gefolgt sind.

10. Verfahren nach Anspruch 8 für die Darstellung einer Legierung nach Anspruch 4,
**dadurch gekennzeichnet,**
daß der Schritt a) eine Stufe mit etwa 1300°C mit einer Dauer von etwa 3 Stunden aufweist,
daß der Schritt b) eine Stufe mit etwa 1100°C mit einer Dauer von etwa 4 Stunden aufweist,
und daß der Schritt c) eine Stufe mit etwa 850°C mit einer Dauer von etwa 24 Stunden aufweist, wobei diese letzten beiden Stufen jeweils von einem Abkühlen an Luft gefolgt sind.

11. Verfahren nach Anspruch 8 für die Darstellung einer Legierung nach Anspruch 5,
**dadurch gekennzeichnet,**
daß der Schritt a) eine Stufe mit etwa 1285°C mit einer Dauer von 2 Stunden aufweist, die von einem Anstieg auf etwa 1295°C in etwa 1 Stunde und von einer Stufe bei dieser letzten Temperatur mit einer Dauer von etwa 2 Stunden gefolgt ist,
daß der Schritt b) eine Stufe mit etwa 1100°C mit einer Dauer von etwa 5 Stunden aufweist,
und daß der Schritt c) eine Stufe mit etwa 850°C mit einer Dauer von etwa 24 Stunden aufweist, wobei diese letzten beiden Schritte jeweils ein Abkühlen an Luft umfassen.

12. Schaufel für eine Turbomaschine, die aus einer Superlegierung nach einem der Ansprüche 1 bis 5 hergestellt und/oder durch ein Verfahren nach einem der Ansprüche 6 bis 11 erhalten ist.

## Claims

1. Nickel-based monocrystalline superalloy suitable for the production of turbo machine blades, characterised in that it contains at least one element selected from erbium and silicon, at a weight concentration of 50 to 500 ppm for Er and 500 to 1000 ppm for Si, and optionally also hafnium at a concentration by weight of 500 to 1500 ppm, the weight concentrations of the elements other than Ni, Er, Si and Hf lying in the following ranges:
| | |
|---|---|
| Cr | 6 to 10% |
| Co | 4 to 8% |
| W | 4.8 to 9% |
| Mo | 0 to 2.5% |
| Al | 4.5 to 6.2% |
| Ti | 0 to 2.2% |
| Ta | 3.3 to 9% |
| B | ≤ 100 ppm |
| C | ≤ 100 ppm |
| Zr | ≤ 100 ppm |

2. Superalloy according to claim 1, characterised in that its weight composition lies in the following range:
| | |
|---|---|
| Cr | 7.8 to 8.3% |
| Co | 5.0 to 6.0% |
| W | 4.8 to 5.2% |
| Mo | 2.1 to 2.4% |
| Al | 5.8 to 6.1% |
| Ti | 1.8 to 2.2% |
| Ta | 3.3 to 3.7% |
| Er | 50 to 100 ppm |
| B | ≤ 10 ppm |
| Zr | ≤ 50 ppm |
| Ni | complement to 100% |

3. Superalloy according to claim 1, characterised in that its weight composition lies in the following range:
| | |
|---|---|
| Cr | 7.8 to 8.3% |
| Co | 5.0 to 6.0% |
| W | 4.8 to 5.2% |
| Mo | 2.1 to 2.4% |
| Al | 5.8 to 6.1% |
| Ti | 1.8 to 2.2% |
| Ta | 3.3 to 3.7% |
| Si | 500 to 700 ppm |
| Hf | 800 to 1500 ppm |
| B | ≤ 10 ppm |
| Zr | ≤ 50 ppm |
| Ni | complement to 100 % |

4. Superalloy according to claim 1, characterised in that its weight composition lies in the following range:
| | |
|---|---|
| Cr | 7.7 to 8.2% |
| Co | 4.8 to 5.4% |
| W | 7.7 to 8.2% |
| Mo | 1.8 to 2.2% |
| Al | 4.85 to 5.1% |
| Ti | 1.3 to 1.6% |
| Ta | 6% |
| C | < 0.01% |
| Si | 500 to 700 ppm |
| Er | 50 to 400 ppm |
| Ni | complement to 100% |

5. Superalloy according to claim 1, characterised in that its weight composition is approximately the following:
| | |
|---|---|
| Cr | 7.5% |
| Co | 6.5% |
| W | 5.5% |
| Mo | 2% |
| Al | 5.2% |
| Ti | 1.2% |
| Ta | 8% |
| Si | 1000 ppm |
| Hf | 1000 ppm |
| Ni | complement to 100% |

6. Process for preparation of a superalloy according to any of the previous claims in which the elements Er and/or Si and where applicable Hf are introduced during production of the parent casting of the alloy.

7. Process for preparation of a superalloy according to any of claims 1 to 5, in which the elements Er and/or Si and where applicable Hf are introduced during the remelt prior to monocrystalline solidification.

8. Process according to any of claims 6 and 7, characterised in that the monocrystalline solidification is followed by successive steps of heat treatment below:
a) dissolution of the γ' phase by heating to a temperature between 1250 and 1350°C inside the heat treatment window of the alloy, for 30 minutes to 4 hours, then cooling in air;
b) precipitation of the γ' phase by heating to a temperature above 1000°C; and
c) increase in the volume fraction of the γ' phase by heating to a temperature between 800 and 900°C for a sufficient time to obtain a γ' precipitate size of the order of 0.5 microns.

9. Process according to claim 8 to obtain an alloy according to claim 2, characterised in that the step a) comprises a stage at approximately 1300°C for approximately 3 hours, step b) a stage at approximately 1050°C for approximately 16 hours and step c) a stage at approximately 850°C for approximately 24 hours, the last two stages each being followed by cooling in air.

10. Process according to claim 8 to obtain an alloy according to claim 4, characterised in that step a) comprises a stage at approximately 1300°C for approximately 3 hours, step b) a stage at approximately 1100°C for approximately 4 hours and step c) a stage at approximately 850°C for approximately 24 hours, the last two stages each being followed by cooling in air.

11. Process according to claim 8 to obtain an alloy according to claim 5, characterised in that step a) comprises a stage at approximately 1285°C for 2 hours followed by an increase to approximately 1295°C in approximately 1 hour and a stage at the latter temperature for approximately 2 hours, step b) comprises a stage at approximately 1100°C for approximately 5 hours and step c) comprises a stage at approximately 850°C for approximately 24 hours, the latter two steps each comprising cooling in air.

12. Turbo machine blade made of a superalloy according to any of claims 1 to 5 and/or obtained by the process according to any of claims 6 to 11.
